**Europäisches Patentamt**

**European Patent Office**

**Office européen des brevets**

(11) Numéro de publication: **0 156 701**

**A1**

(12) # DEMANDE DE BREVET EUROPEEN

(21) Numéro de dépôt: **85400389.4**

(22) Date de dépôt: **28.02.85**

(51) Int. Cl.⁴: **G 01 S 7/22**
**H 03 D 1/22**

---

(30) Priorité: **02.03.84 FR 8403285**

(43) Date de publication de la demande:
**02.10.85 Bulletin 85/40**

(84) Etats contractants désignés:
**DE GB IT NL**

(71) Demandeur: **THOMSON-CSF**
**173, Boulevard Haussmann**
**F-75379 Paris Cedex 08(FR)**

(72) Inventeur: **Lassallette, Jean-Luc**
**THOMSON-CSF SCPI 173, bld Haussmann**
**F-75379 Paris Cedex 08(FR)**

(72) Inventeur: **Lepere, Guy**
**THOMSON-CSF SCPI 173, bld Haussmann**
**F-75379 Paris Cedex 08(FR)**

(72) Inventeur: **Rotat, Gérard**
**THOMSON-CSF SCPI 173, bld Haussmann**
**F-75379 Paris Cedex 08(FR)**

(74) Mandataire: **Benoit, Monique et al,**
**THOMSON-CSF SCPI 173, Bld Haussmann**
**F-75379 Paris Cedex 08(FR)**

---

(54) Dispositif de traitement du signal de réception radar à fréquence intermédiaire et radar comportant un tel dispositif.

(57) L'invention concerne un dispositif de traitement du signal de réception radar à fréquence intermédiaire à détection cohérente comprenant un échantillonneur codeur (10) échantillonnant le signal F1 avec porteuse à une fréquence $f_e = 4f_o/(2k+1)$, $f_o$ étant la fréquence intermédiaire et également la fréquence centrale du filtre (9) adapté de réception; des moyens de démodulation (11 à 14) permettant de générer deux quartets déterminés et d'effectuer le produit du signal échantillonné par chacun de ces quartets pour délivrer deux signaux numériques en quadrature.

Application aux radars à détection cohérente.

./...

Croydon Printing Company Ltd.

FIG_1

# DISPOSITIF DE TRAITEMENT DU SIGNAL DE RECEPTION RADAR A FREQUENCE INTERMEDIAIRE ET RADAR COMPORTANT UN TEL DISPOSITIF

La présente invention concerne les dispositifs de traitement du signal de réception radar à fréquence intermédiaire et plus particulièrement les dispositif de traitement du signal de réception à détection cohérente.

Ces dispositifs sont placés dans une chaîne de réception radar à la sortie de l'amplificateur moyenne fréquence, c'est-à-dire après transposition du signal UHF à fréquence intermédiaire.

Les radars réalisant le filtrage Doppler ou la compression d'impulsions en technique numérique nécessitent l'utilisation de récepteur comportant un dispositif à détection cohérente. Ces dispositifs qui sont également appelés démodulateurs permettent de connaître l'amplitude et la phase des signaux reçus. Les récepteurs radar à détection cohérente comportent classiquement à la suite d'un amplificateur à fréquence intermédiaire deux détecteurs amplitude phase qui coopèrent en quadrature pour effectuer une démodulation d'amplitude et de phase. Ces détecteurs amplitude phase sont contrôlés par le signal de sortie d'un oscillateur local de référence à fréquence intermédiaire. Les signaux vidéo de sortie sont généralement appelés vidéo I et Q.

Généralement les deux voies I et Q qui sont issues des deux détecteurs amplitude phase, sont suivies par deux dispositifs d'échantillonnage et de codage. Un défaut d'équilibrage entre ces deux voies I et Q au niveau de la détection amplitude phase peut apparaître, ce qui donne un léger déséquilibre d'amplitude sur ces deux voies et par ailleurs un défaut de quadrature, autrement dit un déphasage légèrement différent de 90° du signal FI de référence de l'oscillateur local donne également un déséquilibre de phase sur les deux voies I et Q. Ces défauts peuvent être compensés par des algorithmes de calcul très performants mais ils restent malgré tout un élément de limitation des performances des dispositifs de traitement du signal radar. Ils entraînent notamment une remontée des lobes secondaires à la sortie des filtres Doppler ce qui est indésirable. De la même façon cette remontée des lobes secondaires apparaît également dans les dispositifs de compression d'impulsion numérique alors qu'on désire réduire au maximum ces lobes secondaires.

Une autre solution permettant de résoudre ce problème d'équilibrage consiste à utiliser des dispositifs automatiques d'équilibrage du gain et de la quadrature des signaux vidéo I et Q. On peut trouver une description de cette solution dans les articles suivants : "Conférence Radar 82" IEE Conférence publication number 216 p. 46. "Sacrifices in radar clutter suppression due to compromises in implementation of digital Doppler filter". I.W. TAYLOR ; ou IEE Trans. AES 17 p. 131 "the correction of I and Q errors in a coherent-processor". Les dispositifs mis en oeuvre ne sont toutefois pas toujours simples et compliquent parfois la réalisation des dispositif de traitement du signal.

La présente invention a pour objet un dispositif de traitement du signal de réception radar permettant de s'affranchir de ces inconvénients en supprimant les détecteurs amplitude phase sources des déséquilibres entre les deux voies vidéo I et Q d'un radar et en réalisant directement un codage du signal transposé à fréquence intermédiaire avec porteuse puis en multipliant ce signal par deux quartets d'échantillons representatifs des deux porteuses en quadrature pour obtenir les deux voies en quadrature I et Q.

La présente invention a donc pour objet un dispositif de traitement du signal de réception radar à fréquence intermédiaire réalisant une démodulation cohérente consistant à démoduler l'amplitude et la phase du signal reçu S(t), S(t) étant une fonction réelle du temps pouvant se représenter par l'équation :

$$S(t) = a(t) \cos (2 \pi f_0 t + \varphi (t))$$

où a(t) est la modulation d'amplitude, $\varphi (t)$ la modulation de phase et $f_0$ est la fréquence du signal reçu par le radar après transposition en fréquence intermédiaire, cette fréquence étant la fréquence centrale de la bande de réception adaptée $\Delta f$, cette démodulation se faisant en effectuant le produit :

2 S(t) cos 2 $\pi f_o t$ et 2 S(t) sin 2 $\pi f_o t$

puis un filtrage des composants $2f_o$ pour obtenir deux signaux vidéo en quadrature I(t) et Q(t) tels que :

I(t) = a(t) cos $\varphi$ (t) et Q(t) = a(t) sin $\varphi$ (t) ;

caractérisé en ce qu'il comprend :

- un échantillonnage codeur recevant le signal S(t) avec porteuse $f_o$ apte à échantillonner ce signal à une fréquence $f_e = \dfrac{4f_o}{2k+1}$, où $\underline{k}$ est un nombre entier choisi de sorte que $f_e \geqslant 2 \Delta f$ le signal échantillonné étant ainsi représenté pour une suite de quartets représentatifs comportant deux échantillons positifs $e_i$, $e_{i+1}$ et deux échantillons négatifs $e_{i+2}$, $e_{i+3}$ ;

- des moyens de démodulation du signal échantillonné permettant de générer deux quartets (1, 0, -1,0) et (0, +1, 0, -1) et de multiplier respectivement les échantillons ($e_i$, $e_{i+1}$) par (1, 0) et ($e_{i+2}$, $e_{i+3}$) par (-1, 0) et de multiplier respectivement les échantillons ($e_i$,$e_{i+1}$) par (0, +1) et ($e_{i+2}$, $e_{i+3}$) par (0, -1) pour délivrer deux signaux en quadrature.

D'autres particularités et avantages de l'invention apparaîtront clairement à la lecture de la description suivante présentée a titre d'exemple non limitatif et faite en regard des figures du dessin annexé sur lequel :

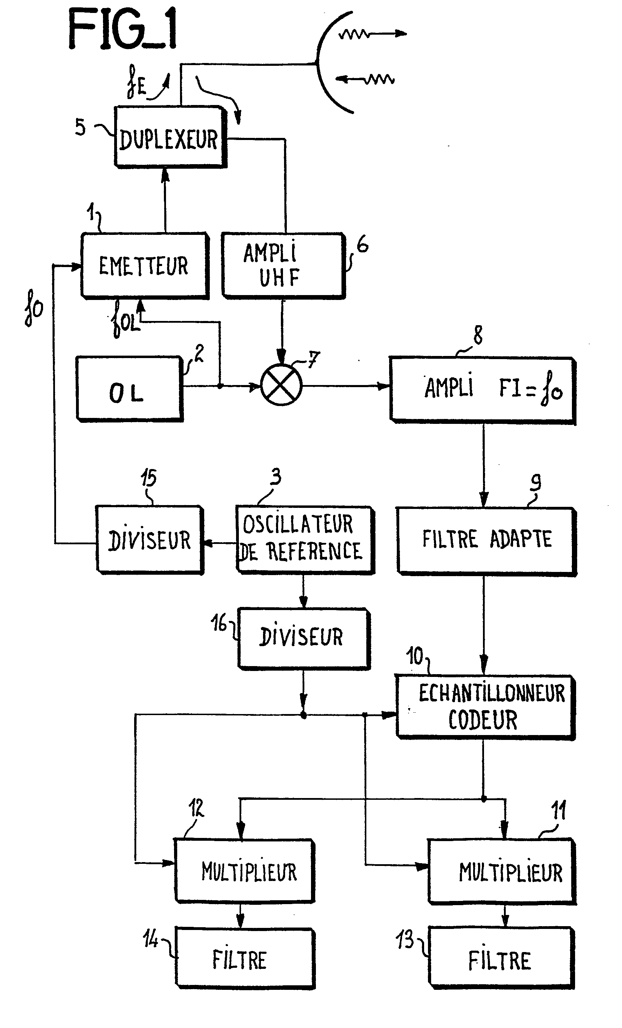

- la figure 1 représente le schéma général d'un émetteur récepteur radar et du dispositif selon l'invention ;

- la figure 2 représente les signaux de sortie des circuits d'échantillonnage et des moyens de démodulation selon la figure 1 ;

- la figure 3 représente une réalisation particulière du dispositif selon la figure 1.

- la figure 4 représente le chronogramme des signaux d'horloge activant les circuits de la réalisation représentée sur la figure 3.

Classiquement, le signal de réception S(t) transposé à fréquence intermédiaire est démodulé par une porteuse à fréquence intermédiaire et par la même porteuse, déphasée de $\frac{\pi}{2}$. Les deux signaux I et Q résultants sont codés puis traités dans une chaîne numérique. Les différences de phase et d'amplitude s'introduisant au niveau de la double démodulation se répercutent dans le traitement fait par les deux chaînes numériques.

Dans la description qui suit, on a pris comme exemple particulier un radar à compression d'impulsion. L'émetteur n'est pas détaillé. Il s'agit d'un émetteur à amplificateur à compression d'impulsion. La fréquence d'émission $f_E$ est donc obtenue par battement de la fréquence $F_{OL}$ du signal émis par un oscillateur local 2 et de la fréquence $f_o$ (appelée fréquence intermédiaire FI) du signal émis par un oscillateur de référence 3.

Le récepteur est un récepteur du type à détection cohérente (double démodulation), faisant donc intervenir une porteuse à fréquence intermédiaire et la même porteuse déphasée de $\frac{\pi}{2}$ pour démoduler le signal reçu qui est modulé en amplitude et en phase et transposé en fréquence intermédiaire.

A la réception, le signal UHF de fréquence $F_E$ reçu par l'antenne 4 est aiguillé par le duplexeur 5 vers un amplificateur UHF 6. L'amplificateur 6 amplifie ce signal et le transmet à un mélangeur 7. Le mélangeur 7 reçoit le signal émis à la fréquence $F_{OL}$ par l'oscillateur local 2 et délivre un signal à fréquence intermédiaire $f_o$ obtenu par battement des deux fréquence $F_E$ et $f_{OL}$. Ce signal est amplifié par un amplificateur 8 à fréquence intermédiaire puis filtré par un filtre 9 de largeur $\Delta f$ correspondant à la bande adaptée à la largeur spectrale du signal émis.

Le signal issu du filtre peut s'écrire :

$$S(t) = a(t) \cos (2 \pi f_o t + \varphi (t))$$

$a(t)$ représente la modulation d'amplitude ;

$\varphi (t)$ représente la modulation de phase ;

$f_o$ est la fréquence intermédiaire du récepteur.

Les signaux de modulation $a(t)$ et $\varphi (t)$ sont des fonctions qui varient lentement dans le temps par rapport à la porteuse

$\cos 2\pi f_o t$. A la sortie du filtre adapté 9 un échantillonneur codeur 10 reçoit ce signal $S(t)$ et l'échantillonne a une fréquence $f_e$ telle qu'elle réponde au théorème d'échantillonnage de Shannon-Nyquist.

Le signal à coder étant un signal avec porteuse, la fréquence maximale à échantillonner est égale à $f_o + \Delta f$. Pour répondre au théorème d'échantillonnage de Shannon-Nyquist, le signal doit être échantillonné à une fréquence au moins égale à $2 f_o + \Delta f$. Cette fréquence d'échantillonnage est toutefois surabondante dans le cas de la modulation à bande étroite et il est possible d'utiliser une fréquence $f_e \geqslant 2\Delta f$. Le choix d'une fréquence d'échantillonnage $f_e = \dfrac{4f_o}{2k+1}$, permet une représentation particulièrement simple car elle permet de réaliser le produit du signal échantillonné par des valeurs $(0, +1, 0, -1)$ et $(+1, 0, -1, 0)$ représentatives des porteuses.

Dans un premier exemple de réalisation, on échantillonne le signal $S(t)$ à la fréquence $4 f_o$, soit $k = o$.

On remarque que la porteuse $\cos 2\pi f_o t$ et la porteuse déphasée de $\dfrac{\pi}{2}$ peuvent être échantillonnées à cette fréquence $f_e = 4f_o$.

Le signal $\cos 2\pi f_o t$ échantillonnée à la fréquence $4 f_o$ aux instants $t = 0$, $t = \dfrac{1}{4f_o}$, $t = \dfrac{1}{2f_o}$, $t = \dfrac{1}{f_o}$ prend les valeurs successives $1, 0, -1, 0$. Le signal $\sin 2\pi f_o t$ échantillonné à la même fréquence aux mêmes instants prend les valeurs successives $0, +1, 0, -1$.

Le signal $S(t)$ échantillonné à ces instants prend les valeurs $e_i$, $e_{i+1}$, $e_{i+2}$, $e_{i+3}$ où $e_i$ et $e_{i+1}$ sont des échantillons positifs et $e_{i+2}$, $e_{i+3}$ sont des échantillons négatifs.

Pour obtenir les deux signaux numérique en quadrature il n'est donc pas nécessaire d'effectuer l'échantillonnage des signaux $\cos 2\pi f_o t$ et $\sin 2\pi f_o t$ à la fréquence $f_e$ mais il suffit de multiplier le signal $S(t)$ échantillonné à la fréquence $4 f_o$ par les valeurs $1, 0, -1, 0$ d'une part et par $0, +1, 0, -1$ d'autre part, aux instants opportuns. Soit $e_i$, $e_{i+1}$, $e_{i+2}$, $e_{i+3}$ le quartet obtenu en prenant quatre

echantillons consécutifs du signal S(t) tel que $e_i$ et $e_{i+1}$ soient positifs et $e_{i+2}$, $e_{i+3}$ soient négatifs. Le signal en phase I est obtenu en effectuant les produits $e_i \times 1$, $e_{i+1} \times 0$, $e_{i+2} \times (-1)$, $e_{i+3} \times 0$, le signal en quadrature Q est obtenu en effectuant les produits $e_i \times 0$, $e_{i+1} \times (+1)$, $e_{i+2} \times 0$, $e_{i+3} \times (-1)$.

Pour supprimer les composantes du signal à la fréquence $2 f_o$ il suffit de ne conserver qu'un échantillon sur deux en supprimant les valeurs nulles.

Il est bien évident que si l'instant $t = 0$ ne correspond pas à celui qui a été choisi dans l'exemple décrit mais donne par exemple une suite d'échantillons tels que les échantillons $e_i$, $e_{i+1}$, sont par exemple un échantillon positif, puis négatif, $e_{i+2}$, $e_{i+3}$ sont alors des échantillons négatifs, puis positifs, les opérations de multiplication doivent subir une rotation en conséquence.

Le signal issu de l'échantillonneur codeur est donc dirigé vers deux multiplieurs 11 et 12 suivi chacun par un filtre 13 et 14 pour réaliser les fonctions décrites précédemment.

Pour généraliser le choix de la fréquence d'échantillonnage $f_e$, il suffit donc de prendre $f_e = \frac{4 f_o}{2k+1}$, $f_o$ étant toujours la fréquence intermédiaire et $\underline{k}$ étant un nombre entier tel que $f_e$ reste toujours très grand par rapport à $2 \Delta f$. La fréquence $f_e$ peut donc par exemple être égale à $4 f_o$, $\frac{4 f_o}{3}$, $\frac{4 f_o}{5}$.

L'oscillateur de référence délivre un signal à une fréquence $4 f_o$ permettant ainsi d'obtenir facilement la fréquence d'échantillonnage et la fréquence intermédiaire $f_o$ utilisée par l'émetteur.

En effet, un diviseur par 4 référencé 15 permet d'obtenir la fréquence $f_o$, à partir du signal émis par l'oscillateur, et un diviseur par $2k + 1$ référencé 16 permet d'obtenir la fréquence $f_e$ à partir de ce même signal $4 f_o$.

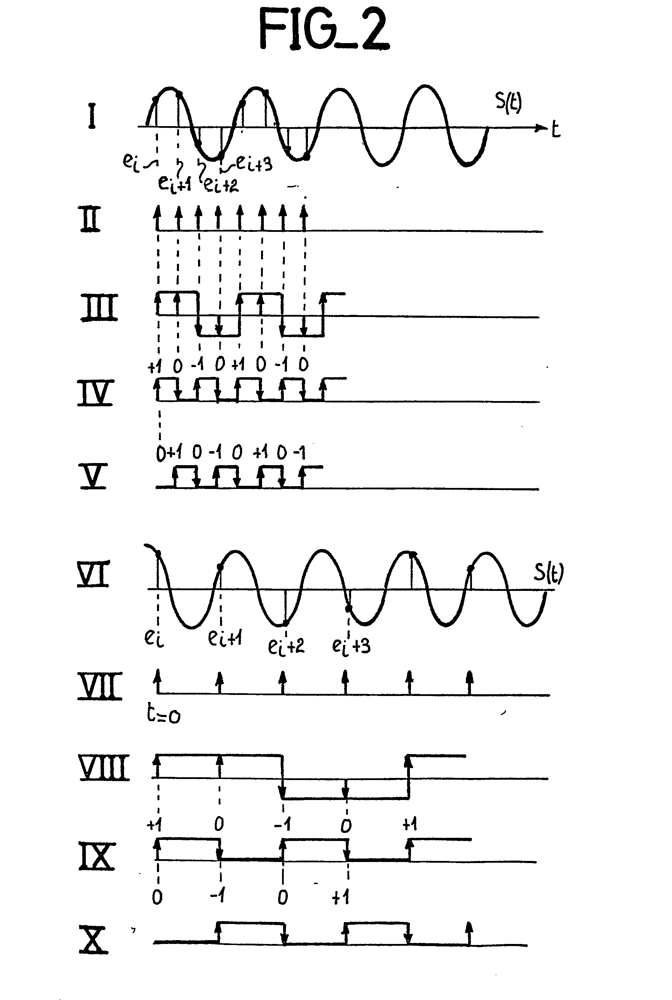

Sur la figure 2 on a représenté les signaux de sortie des circuits pour une première et une deuxième fréquence d'échantillonnage soit $f_e = 4 f_o$ et $f_e = \frac{4}{3} f_o$.

I : représente le signal S(t) à la sortie du filtre adapté 9.

II : représente le signal d'échantillonnage à la fréquence $4f_o$.

III : représente le signal de sortie de l'échantillonneur codeur 10.

IV : représente le signal de sortie du multiplieur 11.

V : représente le signal de sortie du multiplieur 12.

VI : représente le signal $S(t)$ à la sortie du filtre 9.

VII : représente le signal d'échantillonnage à la fréquence $\frac{4f_o}{3}$.

VIII : représente le signal à la sortie de l'échantillonneur codeur 10.

IX : représente le signal à la sortie du multiplieur 11.

X : représente le signal à la sortie du multiplieur 12.

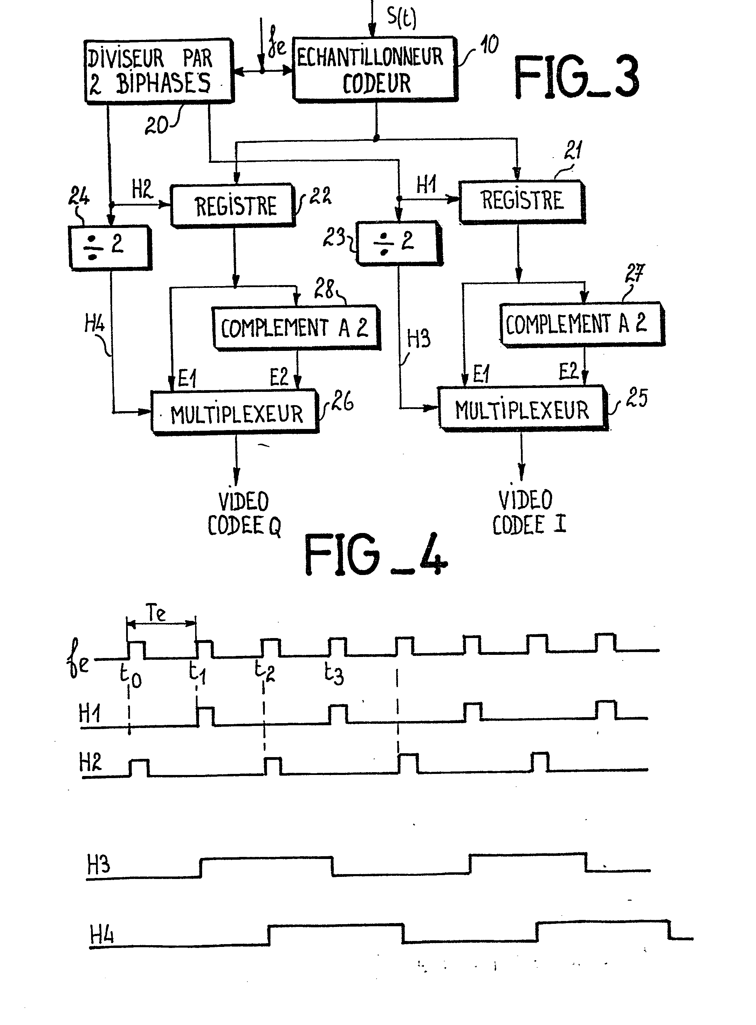

Dans la réalisation particulière représenté sur la figure 3, la fréquence d'échantillonnage est choisi égale à $\frac{4}{3}f_o$, le diviseur 16 étant un diviseur par 3. Le codeur 10 échantillonne et code le signal $S(t)$ au rythme de l'horloge $\frac{4}{3}f_o$.

Un diviseur par 2 biphasé et référencé 20 reçoit le signal d'échantillonnage $f_e$ et délivre deux signaux d'horloge $H_1$ et $H_2$ déphasés, à la fréquence $\frac{f_e}{2}$ qui permettent de piloter deux registres 21 et 22 constitués par exemple par des bascules de type "D". Ces registres 21 et 22 mémorisent chacun les données transmises par le codeur 10. Un diviseur par deux 23 et un diviseur par deux 24 reçoivent chacun le signal d'horloge $\frac{f_e}{2}$ et divisent le signal pour obtenir deux signaux d'horloge $H_3$, $H_4$ de fréquence $\frac{f_e}{4}$ commandant les entrées de sélection de deux multiplexeurs 25 et 26.

Les multiplexeurs 25 et 26 reçoivent respectivement d'une première entrée les données stockées dans les registres 21 et 22 au rythme de l'horloge $\frac{f_e}{2}$ mais avec un décalage dans le temps correspondant au déphasage introduit par le diviseur 20.

Un circuit de complément à deux 27 et un circuit de complément à deux 28 reçoivent respectivement les données stockées dans les registres 21 et 22. Ces circuits complémentent à deux les données et les transmettent à une deuxième entrée respectivement du multiplexeur 25 et 26. Les circuits de complément à deux sont connus en soi, ils peuvent par exemple être réalisés par une unité arithmétique et logique.

Le signal d'horloge $H_3$ commandant la sélection de l'une des entrées puis de l'autre permet au multiplexeur 25 de délivrer le signal vidéo, codé I. Le signal d'horloge $H_4$ commandant la sélection de l'une des entrées puis de l'autre permet au multiplexeur 26 de délivrer le signal vidéo codé Q. Ces signaux sont exploités par un organe de traitement adapté à la technique utilisée, soit dans cet exemple un filtrage de compression d'impulsion.

Le diviseur 20 qui permet d'obtenir des signaux d'horloge deux fois moins rapides que le signal d'échantillonnage $f_e$ permet de ne stocker qu'un échantillon sur deux.

Sur la figure 4 on a représenté le chronogramme des signaux d'horloge utilisés pour le fonctionnement des circuits de la figure 3.

Soient $t_0$, $t_1$, $t_2$, $t_3$ des instants d'échantillonnage du signal d'horloge de fréquence $f_e$ activant le codeur 10 qui délivre respectivement les échantillons $e_i$, $e_{i+1}$, $e_{i+2}$, $e_{i+3}$.

Ces échantillons sont stockés dans le resgistre 21 et 22. Le registre 21 délivre l'échantillon $e_i$ à l'instant $t_2$. Cet échantillon est dirigé vers l'entrée E1 du multiplexeur 25 et vers l'entrée E2 de ce multiplexeur via le circuit de complément à deux 27. Un état haut de l'horloge $H_3$ permet de sélectionner par exemple l'entrée E1 du multiplexeur 25, l'état bas permettant donc de sélectionner l'entrée E2. Entre les instants $t_1$ et $t_3$ l'état de l'horloge $H_3$ est haut et en particulier entre les instants $t_2$ et $t_3$. L'échantillon arrivé à l'entrée $E_1$ est maintenant à la sortie du multiplexeur 25. L'horloge $H_4$ étant déphasée d'une demi-période par rapport $H_3$, entre les instants $t_2$ et $t_3$, celle-ci est à l'état haut et c'est l'échantillon $e_{i+1}$ qui est maintenant à la sortie du registre 26. Entre les instants $t_3$ et $t_5$ c'est l'échantillon complémenté à deux de $e_{i+1}$ qui est à la sortie du multiplexeur 25. Ces circuits permettent donc d'effectuer les multiplications par (+1) et par (-1) en faisant un complément à deux et également d'effectuer le filtrage désiré consistant à supprimer les produits nuls.

Les multiplexeurs et les circuits permettant d'effectuer un complément à deux peuvent être remplacés par des mémoires mortes programmées (PROM) assurant les fonctions de multiplications par (0, + 1, 0, -1) et par (+ 1, 0, -1, 0) puis le filtrage des échantillons nuls.

L'invention permet donc d'effectuer un traitement numérique du signal reçu transposé en fréquence intermédiaire et de plus de supprimer l'étage de génération et d'échantillonnage des signaux porteurs en quadrature qui permettent de démoduler le signal reçu, la démodulation s'effectuant en opérant une multiplication du signal par deux quartets constitués d'échantillons déterminés.

## REVENDICATIONS

1. Dispositif de traitement du signal de réception radar à fréquence intermédiaire réalisant une démodulation cohérente consistant à démoduler l'amplitude et la phase du signal reçu $S(t)$, $S(t)$ étant une fonction réelle du temps pouvant se représenter par l'équation :

$$S(t) = a(t) \cos (2\pi f_o t + \varphi(t))$$

où $a(t)$ est la modulation d'amplitude, $\varphi(t)$ la modulation de phase et $f_o$ est la fréquence du signal reçu par le radar après transposition en fréquence intermédiaire, cette fréquence étant la fréquence centrale de la bande adaptée de réception $\Delta f$, cette démodulation se faisant en effectuant les produits :

$$2 S(t) \cos 2\pi f_o t \text{ et } 2 S(t) \sin 2\pi f_o t$$

puis un filtrage des composantes $2f_o$ pour obtenir deux signaux vidéo en quadrature $I(t)$ et $Q(t)$ tels que :

$$I(t) = a(t) \cos \varphi(t) \text{ et } Q(t) = a(t) \sin \varphi(t) ;$$

caractérisé en ce qu'il comprend :

- un échantillonneur codeur (10) recevant le signal $S(t)$ avec porteuse $f_o$ apte à échantillonner ce signal à une fréquence $fe = \dfrac{4f_o}{2k+1}$ où $\underline{k}$ est un nombre entier choisi de sorte que $f_e \gg 2 \Delta f$ le signal échantillonné étant ainsi représenté par une suite de quartets représentatifs comportant deux échantillons positifs $e_i$, $e_{i+1}$ et deux échantillons négatifs $e_{i+2}$, $e_{i+3}$ ;

- des moyens de démodulation (11 à 14) du signal échantillonné permettant de générer deux quartets $(1, 0, -1, 0)$ et $(0, +1, 0, -1)$ et de multiplier respectivement les échantillons $(e_i, e_{i+1})$ par $(1, 0)$ et $(e_{i+2}, e_{i+3})$ par $(-1, 0)$ et de multiplier respectivement les échantillons $(e_i, e_{i+1})$ par $(0, 1)$ et $(e_{i+2}, e_{i+3})$ par $(0, -1)$ pour délivrer deux signaux en quadrature.

2. Dispositif selon la revendication 1, caractérisé en ce que les moyens de démodulation (11, 12) (13, 14) comprennent un premier multiplieur (11) apte à former le premier quartet comportant les quatre échantillons consécutifs (+1, 0, -1, 0) pour multiplier respectivement le premier $e_i$, le deuxième $e_{i+1}$, le troisième $e_{i+2}$ et le quatrième $e_{i+3}$, échantillon du signal issu du décodeur (10) un deuxième multiplieur (12) apte à former le deuxième quartet comportant quatre échantillons consécutifs (0, +1, 0, -1) pour multiplier respectivement les premier $e_i$, deuxième $e_{i+1}$, troisième $e_{i+2}$ et quatrième $e_{i+2}$ échantillon issu du décodeur (10).

3. Dispositif selon la revendication 1 ou 2, caractérisé en ce que les moyens de démodulation (13, 14) comprennent un premier (13) et un deuxième filtre (14) pour filtrer les produits nuls.

4. Dispositif selon l'une quelconque des revendications 1 à 3, caractérisé en ce que la fréquence d'échantillonnage $f_e$ est obtenue par un oscillateur de référence (3) délivrant un signal à une fréquence $4f_o$ suivi d'un diviseur (16) par 2k+1.

5. Dispositif selon l'une quelconque des revendications 1 à 4, caractérisé en ce que l'oscillateur de référence (3) permet également de fournir la fréquence intermédiaire $f_o$ au moyen d'un diviseur (15) par quatre, utilisée par l'émetteur du radar.

6. Dispositif selon l'une quelconque des revendications 1 à 9, caractérisé en ce que les multiplieurs comportent un registre (21, 22) recevant les échantillons du codeur (10) et délivrant ces échantillons au rythme d'une horloge respectivement $H_1$ et $H_2$ égale à $f_e/2$, décalées d'une période l'une par rapport à l'autre, un multiplexeur (25, 26) dont une entrée (E1) reçoit directement ces échantillons et dont l'autre entrée reçoit ces échantillons complémentés à deux correspondant à une multiplication par -1 par un circuit de complément à deux (27, 28).

7. Dispositif selon la revendication 5, caractérisé en ce que les entrées (E1 et E2) des multiplexeurs (25), (26) sont sélectionnées à l'aide d'une horloge respectivement $H_3$ et $H_4$ de fréquence $f_e/4$ permettant de sélectionner à la sortie un échantillon ou le complément à deux de l'échantillon consécutif avec un décalage d'une période égale à $1/f_e$ entre les sorties des deux multiplexeurs (25 et 26).

8. Dispositif selon la revendication 6 ou 7, caractérisé en ce que les horloges $H_1$ et $H_2$ sont obtenues au moyen d'un diviseur par deux (20) recevant le signal d'échantillonnage $f_e$.

9. Dispositif selon la revendication 7 ou 8, caractérisé en ce que les horloges $H_3$ et $H_4$ sont obtenue respectivement par un diviseur par deux (23) et (24) recevant les signaux d'horloge $H_1$ et $H_2$.

10. Dispositif selon l'une quelconque des revendications 1 à 5, caractérisé en ce que une mémoire programmable (PROM) est reliée à la sortie de chaque registre (21) (22) permettant d'effectuer les produits et le filtrage nécessaire pour délivrer deux signaux numériques en quadrature.

FIG_1

0156701

1/3

FIG_2

FIG_3

FIG_4

Office européen
des brevets

**RAPPORT DE RECHERCHE EUROPEENNE**

EP 85 40 0389

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | IEEE TRANSACTIONS ON AEROSPACE AND ELECTRONIC SYSTEMS, volume 18, no. 4, novembre 1982, New York, US; W.M. WATERS et al.: "Bandpass signal sampling and coherent detection", pages 731-736<br>* Figures 1-3; pages 731-732, paragraphe "Calculation of I and Q from if samples" * | 1-3 | G 01 S 7/22<br>H 03 D 1/22 |
| | --- | | |
| A | US-A-4 344 040 (J.P. REILLY et al.)<br>* En entier * | 1 | |
| | --- | | |
| X,P | EP-A-0 109 121 (HOLLANDSE SIGNAALAPPARATEN)<br>* Figures 1,2; page 1, ligne 22 - page 5, ligne 11 * | 1-3,6 | |
| | ----- | | |

**DOMAINES TECHNIQUES RECHERCHES (Int. Cl.4)**

G 01 S
H 03 D

Le présent rapport de recherche a été établi pour toutes les revendications

| Lieu de la recherche | Date d'achèvement de la recherche | Examinateur |
|---|---|---|
| LA HAYE | 05-06-1985 | CANNARD J.M. |